Europäisches Patentamt

European Patent Office

Office européen des brevets

(19)

(11) **EP 0 743 696 B1**

(12) **EUROPEAN PATENT SPECIFICATION**

(45) Date of publication and mention
of the grant of the patent:
**06.06.2001 Bulletin 2001/23**

(51) Int Cl.⁷: **H01P 1/205**

(21) Application number: **96107824.3**

(22) Date of filing: **15.05.1996**

(54) **Dielectric filter and method of manufacturing same**

Dielektrisches Filter und Verfahren zu dessen Herstellung

Filtre diélectrique et procédé de fabrication

(84) Designated Contracting States:
**DE FR GB**

(30) Priority: **19.05.1995 JP 12174295**

(43) Date of publication of application:
**20.11.1996 Bulletin 1996/47**

(73) Proprietor: **MURATA MANUFACTURING CO., LTD.**
**Nagaokakyo-shi Kyoto-fu 226 (JP)**

(72) Inventors:
 • **Miyamoto, Hirofumi**
 **Nagaokakyo-shi, Kyoto-fu (JP)**
 • **Katoh, Hideyuki**
 **Nagaokakyo-shi, Kyoto-fu (JP)**

(74) Representative: **Schoppe, Fritz, Dipl.-Ing.**
 **Schoppe, Zimmermann & Stöckeler**
 **Patentanwälte**
 **Postfach 71 08 67**
 **81458 München (DE)**

(56) References cited:
 **EP-A- 0 520 699**       **EP-A- 0 645 836**
 **GB-A- 2 278 963**

## Description

BACKGROUND OF THE INVENTION

1. Field of the Invention

The present invention relates to dielectric filters and manufacturing methods thereof, and more particularly, to a dielectric filter having an input/output electrode on its outer surface, the input/output electrode being insulated by a gap from the outer conductor applied to the outer surface, and a manufacturing method thereof.

2. Description of the Related Art

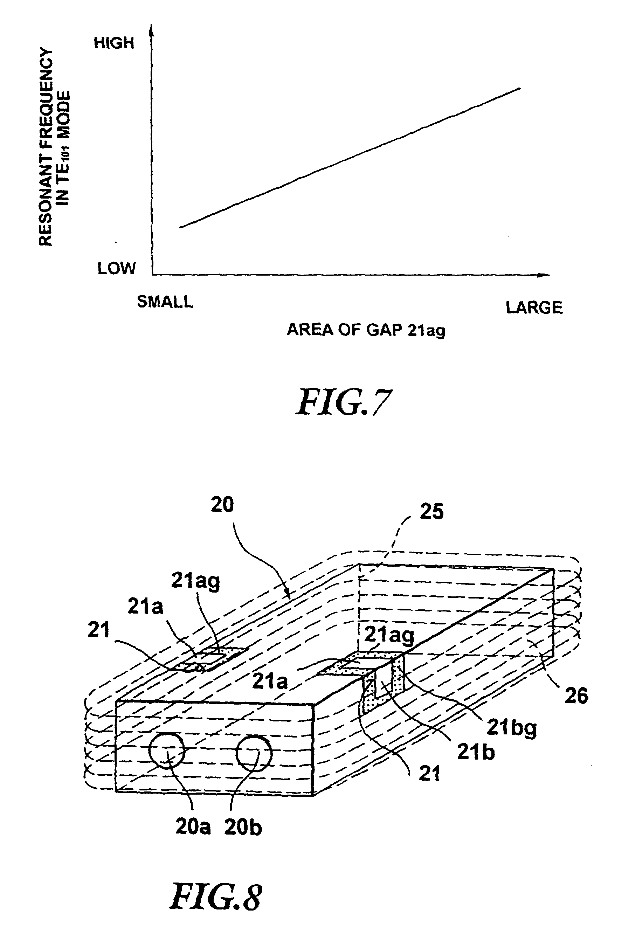

A conventional TEM-mode dielectric filter, as shown in Fig. 8, includes a dielectric block 20, two resonator holes 20a and 20b passing through the block, and input and output electrodes 21a and 21b. A conductive material is applied to the outer surface of the dielectric block 20 and to the inner surfaces of the resonator holes 20a and 20b to form an outer conductor and inner conductor, respectively.

Gaps are provided at the inner surfaces of the resonator holes 20a and 20b. Gaps 21ag and 21bg are also provided around the input and output electrodes 21a and 21b in order to insulate the electrodes from the outer conductor. These gaps are formed by removing the applied conductive material from the dielectric with an appropriate method such as cutting. With this configuration, the input and output electrodes 21a and 21b are capacity-coupled with the conductors inside the resonator holes.

When the dielectric block 20 is mounted on a printed circuit board, a surface 25 touches the board and the electrodes 21a and 21b on the surface 25 come into contact with patterns printed on the board and are connected thereto through solder. The electrodes 21b are extended onto a side face 26 of the block. These extended electrodes are provided in order to enlarge the area of the contact between the electrode and the solder to secure the dielectric block 20 more firmly to the board.

When the electrodes 21b extending downward in the figure are enlarged, the area of the gap 21bg also increases and the characteristics of the dielectric filter change. Therefore, it is preferred to limit the size of the electrode 21b, to have the minimum area required for soldering.

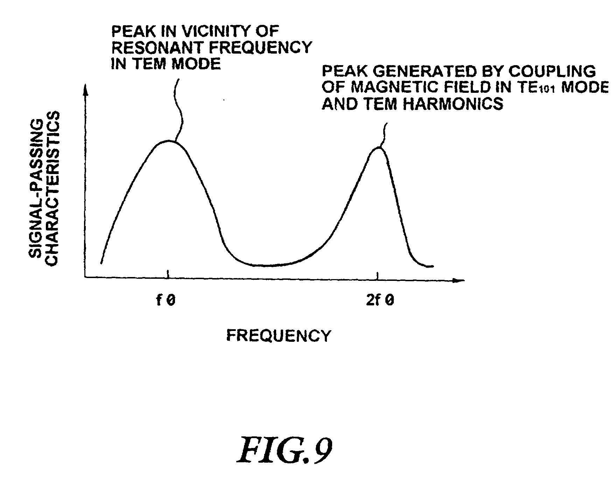

In a dielectric filter of this type, having different configurations in the upper and lower halves of the block, a magnetic field of the $TE_{101}$ mode is generated as shown by dotted lines in Fig. 8. Since this magnetic field resonates with a spurious signal generated at a frequency of about 2f0, which is twice the frequency of the TEM mode, the dielectric filter 20 passes signals having frequencies of around 2f0 (see Fig. 9). This is a drawback of the dielectric filter 20, which has a target frequency of f0.

GB-A-2278963 discloses a microwave ceramic filter comprising a one-piece ceramic body, a metal film on all surfaces of the ceramic body with the exception of a single end face, at least two resonators constituted in each case by an inner-conductor bore within the one-piece ceramic body and coupling structures provided within the ceramic body with respect to the inner-conductor bores.

Summary of the Invention

Accordingly, it is an object of the present invention to provide a dielectric filter which passes a signal having a frequency of f0 in the TEM mode and suppresses signals having frequencies of around 2f0, and a manufacturing method thereof.

This object is achieved by a dielectric filter according to claim 1 and by a method for manufacturing a dielectric filter according to claim 12.

The principle for achieving the foregoing object will be described below.

In the distribution of the electromagnetic field in $TE_{101}$ mode generated around the dielectric block 20, the magnetic field is localized inside the block in the vicinity of the walls and the electric field is localized at the center of the block. Although the dotted lines are drawn around the block for convenience in drawing, the magnetic field is actually distributed inside the block as well.

The electrodes 21a of the dielectric block 20 are extended from a side of the block toward the center of the block, and the electrode 21b is extended vertically in the figure on a side of the block. This means that the electrode 21a has a stronger influence on the electric field as compared with the magnetic field. By contrast, the electrode 21b has a stronger influence on the magnetic field. When the gap area adjacent the electrode 21a is reduced, the level of electric-field trapping in the dielectric block 20 increases and the electric energy in the dielectric block is increased.

The relationship between a change $\Delta\omega$ in the angular resonant frequency, and minute changes $\triangle Wm$ and $\triangle We$ in the magnetic energy and electric energy in a resonator, respectively is expressed by the Müller equation:

$$\Delta\omega/\omega_o = (\triangle Wm - \triangle We)/Wt \qquad (1)$$

where $\omega_o$ indicates the angular resonant frequency of an electromagnetic wave in a certain mode, Wm and We represent the time averages of the magnetic energy and the electric energy trapped in the resonator, and Wt is the total resonance energy.

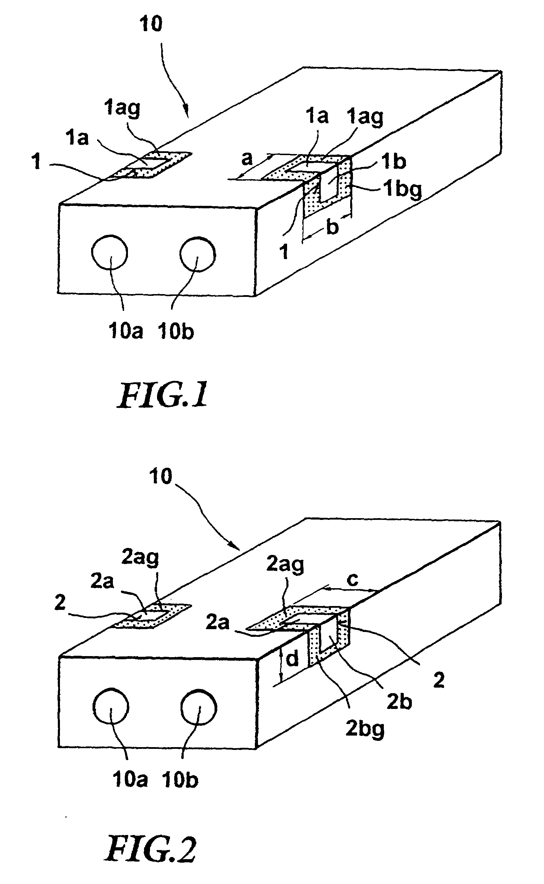

According to expression (1), when the area of the gap 21ag adjacent the electrode 21a decreases, the electric energy in $TE_{101}$ mode trapped in the dielectric block increases, and the resonant frequency is reduced. In other words, the resonant frequency shifts toward a lower frequency from 2f0 (see Fig. 7). For instance, in a filter of Fig. 1, 2mm decrease of gap width "a" caused 97MHz shift of the $TE_{101}$ mode resonant frequency toward a lower frequency.

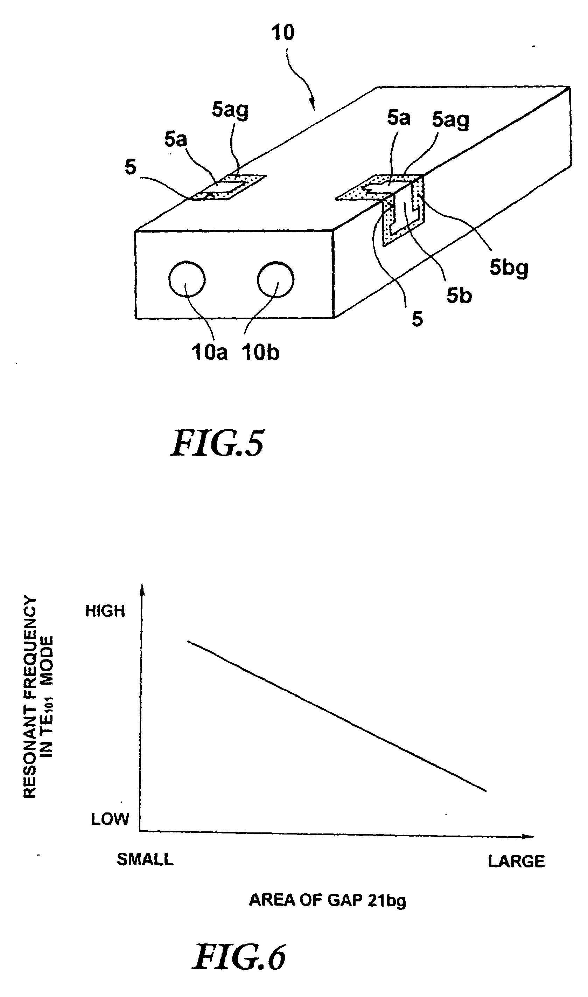

In the same way, when the gap area 21bg adjacent the electrode 21b decreases, the magnetic energy trapped in the dielectric block increases, and the resonant frequency shifts toward a higher frequency from 2f0 (see Fig. 6). For example, 2mm decrease of gap width "b" resulted in 109MHz shift of the $TE_{101}$ mode resonant frequency toward a higher frequency.

According to the considerations described above, in the present invention, the areas of the gaps in the vicinity of the respective electrodes, namely, the exposed areas of the dielectric, are controlled to shift the resonant frequency in the $TE_{101}$ mode as required. Thereby, resonance between the harmonics having frequencies of about 2f0 in the TEM mode and the magnetic field of the $TE_{101}$ mode is suppressed. As a result, the dielectric filter restricts the passage of signals having frequencies of about 2f0.

The foregoing object is achieved in one aspect of the present invention through the provision of a dielectric filter having a resonant frequency f, comprising: a dielectric block; an outer conductor covering the outside surface of the dielectric block; a resonator configured with holes passing through the dielectric block and inner conductors covering inner surfaces of the holes; at least one electrode disposed at a surface of the dielectric block; and a gap in the outer conductor insulating the electrode from the outer conductor, wherein the area of the gap in the outer conductor is determined such that the dielectric filter is substantially prevented from resonating at harmonics of a signal having a frequency f.

The foregoing object is achieved in another aspect of the present invention through the provision of a TEM-mode dielectric filter, comprising: a dielectric block; an outer conductor covering the outside surface of the dielectric block; a resonator configured with holes passing through the dielectric block and inner conductors covering inner surfaces of the holes; at least one electrode disposed at a surface of the dielectric block; and a gap in the outer conductor which insulates the electrode from the outer conductor, wherein the area of the gap in the outer conductor is determined such that the central frequency in the $TE_{101}$ mode is substantially different from multiples of the central frequency in the TEM mode.

The foregoing object is achieved in still another aspect of the present invention through the provision of a TEM-mode dielectric filter, comprising: a dielectric block having a substantially hexahedron shape; an outer conductor covering the outside surface of the dielectric block; a resonator configured with holes passing through the dielectric block and inner conductors covering inner surfaces of the holes; a first electrode provided on a first surface of the dielectric block; a first gap in the outer conductor provided around the first electrode in order to insulate the first electrode from the outer conductor; a second electrode provided on a surface of the dielectric block which is adjacent to the first surface, with the second electrode being connected to the first electrode; and a second gap in the outer conductor provided around the second electrode in order to insulate the second electrode from the outer conductor; wherein the respective areas of the first and second gaps in the outer conductor are determined such that the central frequency in $TE_{101}$ mode is substantially different from multiples of the central frequency in the TEM mode.

The foregoing object is achieved in a further aspect of the present invention through the provision of a manufacturing method of a dielectric filter having a resonant frequency f comprising the steps of: preparing a dielectric block; providing an outer conductor covering the outer surface of the dielectric block; providing a resonator configured with holes passing through the dielectric block and an inner conductor covering the inner surfaces of the holes; selecting a first electromagnetic-field mode; specifying an area in the dielectric block having a high electric-field density or a high magnetic-field density in the first electromagnetic-field mode; disposing at least one electrode in the specified area; and providing on the outer conductor a gap in order to insulate the electrode from the outer conductor, the gap having an area which is selected to substantially prevent the dielectric filter from resonating at harmonics of a signal having a frequency of f.

Other features and advantages of the present invention will become apparent from the following description of embodiments of the invention which refers to the accompanying drawings.

BRIEF DESCRIPTION OF THE DRAWINGS

Fig. 1    is a perspective view of a dielectric filter according a first embodiment of the present invention.

Fig. 2    is a perspective view of a dielectric filter according to a second embodiment of the present invention.

Fig. 3    is a perspective view of a dielectric filter according to a third embodiment of the present invention.

Fig. 4    is a perspective view of a dielectric filter according to a fourth embodiment of the present invention.

Fig. 5    is a perspective view of a dielectric filter according to a fifth embodiment of the present invention.

Fig. 6    is a chart showing the relationship between the area of a gap 21bg and the resonant frequency in $TE_{101}$ mode.

Fig. 7    is a chart showing the relationship between the area of a gap 21ag and the resonant frequency in $TE_{101}$ mode.

Fig. 8    is a perspective view of a conventional dielectric filter.

Fig. 9    is a view showing the signal-passing characteristics of the conventional dielectric filter.

DETAILED DESCRIPTION OF THE PREFERRED EMBODIMENTS

The dielectric filter shown in Fig. 1 includes a dielectric block 10, two resonator holes 10a and 10b passing through the block, and input and output electrodes la and 1b. A conductive material is applied to the outer surface of the dielectric block 10 and to the inner surfaces of the resonator holes 10a and 10b to form the outer conductor and the inner conductors.

Gaps are provided at the inner surfaces of the resonator holes 10a and 10b (not shown). Gaps 1ag and 1bg are also provided around the input and output electrodes la and 1b in order to insulate the electrodes from the outer conductor. These gaps are formed by removing the applied conductive material from the dielectric by an appropriate method such as cutting. With this configuration, the input and output electrodes la and 1b are capacity-coupled with the conductors inside the resonator holes.

In this dielectric filter, the combined width "a" of the electrode la and a gap lag is smaller than the combined width "b" of the electrode 1b and gap 1bg. However, the electrodes la and 1b have the same width. Accordingly, the area of the gap lag is made smaller than that of the gap 1bg. By reducing the area of the gap lag, the level of trapping the electric field in the dielectric filter increases. By enlarging the area of the gap 1bg, the level of trapping the magnetic field in the dielectric filter decreases.

As clearly understood from expression (1), the resonant frequency in the $TE_{101}$ mode shifts toward a lower frequency with this configuration. As a result, coupling between the magnetic field of the $TE_{101}$ mode and the harmonics of the signal having a frequency of f0 is reduced and the dielectric filter therefore has the characteristic of not passing signals having frequencies of about 2f0. Alternatively, the resonant frequency in $TE_{101}$ mode may be shifted toward a higher frequency by making the area of the gap lag larger than that of the gap 1bg.

Fig. 2 shows a dielectric filter according to another embodiment of the present invention. The dielectric filter is the same as that shown in Fig. 1 except for the input/output electrodes 2a and 2b and the gaps 2ag and 2bg therefor. In this dielectric filter, the widths of the gaps are the same. The length "c" of the gap 2ag is made longer than the length "d" of the gap 2bg in order to make the area of the gap 2ag larger than that of the gap 2bg. Alternatively, the area of the gap 2ag may be made smaller than that of the gap 2bg.

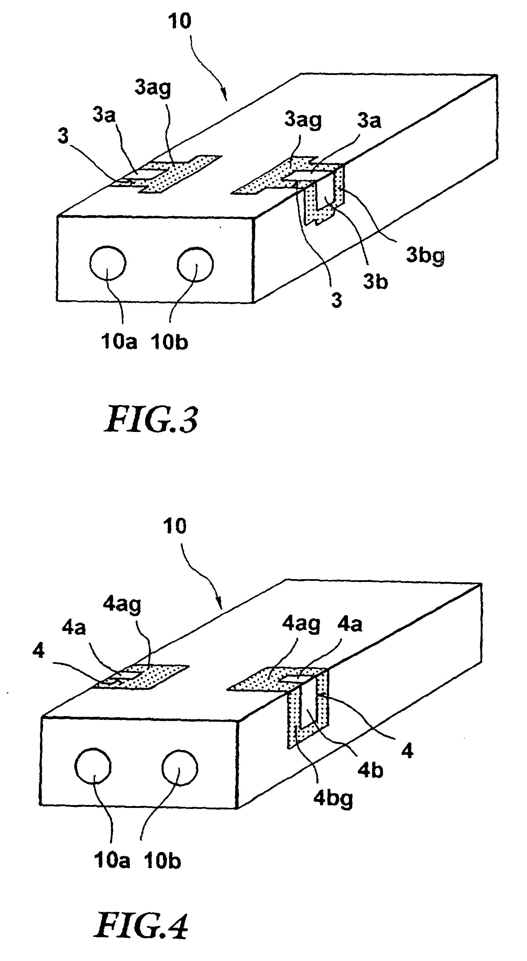

In the dielectric filter shown in Fig. 3, additional gaps are added to the tips of the gaps shown in any of the embodiments described above to form T-shaped gaps 3ag and 3bg. By adjusting the areas of the added gaps, the areas of the gaps 3ag and 3bg can be set as desired, and the resonant frequency in $TE_{101}$ mode can be shifted by the desired amount in the desired direction.

In the dielectric filter shown in Fig. 4, the combined dimensions of the electrodes 4a and 4b and the respective gaps 4ag and 4bg are the same, but the lengths and widths of the electrodes differ as shown in Fig. 4, to implement a difference in the areas of the gaps 4ag and 4bg.

In the dielectric filter shown in Fig. 5, the shapes of the electrodes differ, while the outer shapes of gaps Sag and 5bg are the same. Therefore, in this embodiment the gap 5ag is larger than the gap 5bg.

In any of the foregoing embodiments, it is understood that the areas of the gaps are determined according to the principle that the area of a gap provided on the upper surface of a dielectric block and that of a gap provided on the side face of the block have different influences on the amount and direction of the shift of the resonant frequency in the $TE_{101}$ mode.

The shapes of the electrodes and the gaps in the foregoing embodiments may be appropriately selected according to convenience in design and manufacturing. Lengths, widths, and shapes, or any of these factors, can be selected for the input/output electrodes, the respective surrounding gaps, or both. Other embodiments can also be considered within the concept of the present invention.

The number of gaps provided on the surface of a dielectric block and the positions thereof are not limited to those described in the foregoing embodiments. According to the purpose, various types of gaps may be selected.

In the embodiments, dielectric filters having a hexahedron shape are shown. The present invention can be also applied to a dielectric filter having another shape. In other words, first, the positions where an electric field and a magnetic field are localized are specified in a dielectric filter, and then electrodes and gaps insulated from the outer conductor are provided in the vicinity of each such position. The areas of the gaps are adjusted such that the desired advantages, namely, the amount and direction of the shift of the resonant frequency in the specified mode, are obtained.

Although the present invention has been described in relation to particular embodiments thereof, many other variations and modifications and other uses will become apparent to those skilled in the art. Therefore, the present invention is not limited by the specific disclosure herein.

## Claims

1. A dielectric filter having a resonant frequency f, comprising:

   a dielectric block (10);

   an outer conductor covering the outside surface of said dielectric block (10);

   a resonator configured with holes (10a, 10b) passing through said dielectric block (10) and inner conductors covering inner surfaces of said holes (10a, 10b);

   a first electrode (1a, 1b; 2a, 2b; 3a, 3b; 4a, 4b; 5a, 5b) disposed on a first surface of said dielectric block (10); and

   a first gap (1ag, 1bg; 2ag, 2bg; ...; 5ag, 5bg) in said outer conductor insulating said electrode (la to 5b) from said outer conductor,

   characterized in that
   said gap (1ag to 5bg) in said outer conductor has an area which is determined such that said dielectric filter is prevented from resonating at harmonics of a signal having a frequency f.

2. A dielectric filter according to claim 1, wherein said dielectric filter is a TEM-mode filter and said area is determined such that the center frequency in the $TE_{101}$ mode is different from multiples of the center frequency in the TEM mode.

3. A dielectric filter according to claim 1, wherein

   said dielectric filter is a TEM-mode dielectric filter;

   said dielectric block (10) has a substantially hexahedron shape; and

   said first gap (1ag; 2ag; 3ag; 4ag; 5ag) in said outer conductor is provided around the first electrode (la to 5a);

   said dielectric filter further comprising:

      a second electrode (1b; 2b; 3b; 4b; 5b) provided on a second surface of the dielectric block (10) which is adjacent to the first surface, said second electrode (1b to 5b) being connected to said first electrode (la to 5a); and

      a second gap (1bg; 2bg; 3bg; 4bg; 5bg) in the outer conductor provided around said second electrode (1b to 5b) in order to insulate said second electrode (1b to 5b) from said outer conductor;

      wherein the respective areas of said first and second gaps (1ag, 1bg to 5ag, 5bg) in said outer conductor are determined such that the center frequency in $TE_{101}$ mode is different from multiples of the center frequency in the TEM mode.

4. A TEM-mode dielectric filter according to claim 3, wherein the area of said first gap (2ag; 3ag; 4ag; 5ag) provided in said outer conductor is larger than the area of said second gap (2bg; 3bg; 4bg; 5bg) provided in said outer conductor.

5. A TEM-mode dielectric filter according to claim 3, wherein the area of said first gap (1ag) provided in said outer conductor is smaller than the area of said second gap (1bg) provided in said outer conductor.

6. A dielectric filter as in claim 1 or 2, further comprising:

   a second electrode (1b; 2b; 3b; 4b; 5b) electrically connected to said first electrode (1a to 5a) and disposed on a second surface of said dielectric block (10) adjoining said first surface; and

   a second gap (1bg; 2bg; 3bg; 4bg; 5bg) in said outer conductor insulating said second electrode (1b to 5b) from said outer conductor,

   wherein said dielectric filter is prevented from resonating at harmonics of frequency f in response to a relationship between relative areas of said first gap (1ag to 5ag) and said second gap (1bg to 5bg).

7. A dielectric filter as in claim 6, wherein said first gap (3ag) and said second gap (3bg) have different outer shapes.

8. A dielectric filter as in claim 6, wherein said first gap (1ag; 2ag; 4ag; Sag) and said second gap (1bg; 2bg; 4bg; 5bg) have the same outer shape.

9. A dielectric filter as in claim 7 or 8, wherein said first electrode (4a; 5a) and said second electrode (4b;

5b) have different shapes.

**10.** A dielectric filter as in claim 6, wherein said first electrode (1a; 2a; 3a) and said second electrode (1b; 2b; 3b) have the same shape.

**11.** A dielectric filter as in any of claims 6 to 10, wherein said dielectric block (10) is hexahedron-shaped.

**12.** A manufacturing method of a dielectric filter having a resonant frequency f comprising the steps of:

preparing a dielectric block (10);

providing an outer conductor covering the outer surface of said dielectric block (10);

providing a resonator configured with holes (10a, 10b) passing through said dielectric block (10) and an inner conductor covering the inner surfaces of said holes (10a, 10b);

disposing at least one first electrode (1a; 2a; 3a; 4a; 5a) on said outer surface of said dielectric block; and

providing on said outer conductor a first gap (1ag; 2ag; 3ag; 4ag; 5ag) in order to insulate the electrode (1a to 5a) from the outer conductor; characterized by the following steps:

selecting a first electromagnetic-field mode;

specifying a first area in the dielectric block (10) having a high electric-field density or a high magnetic-field density in said first electromagnetic-field mode, wherein said first electrode is disposed in the first area; and

adjusting an area of said gap (1ag to 5ag) so as to prevent said dielectric filter from resonating at harmonics of a signal having a frequency f.

**13.** A manufacturing method as in claim 12, further comprising the steps of:

specifying a second area in the dielectric block (10) having a high electric-field density or a high magnetic-field density at a multiple of frequency f in a second electromagnetic-field mode,

disposing at least one second electrode (1b to 5b) in the second area;

providing on said outer conductor a second gap (1bg; 2bg; 3bg; 4bg; 5bg) in order to insulate said second electrode (1b to 5b) from the outer conductor; and

adjusting respective areas of said first and second gaps such that the center frequency in said second mode is different from multiples of the center frequency in the first mode.

**14.** A method as in claim 13, wherein said first gap (3ag) and said second gap (3bg) have different outer shapes.

**15.** A method as in claim 13, wherein said first gap (1ag; 2ag; 4ag; 5ag) and said second gap (1bg; 2bg; 4bg; 5bg) have the same outer shape.

**16.** A method as in claim 14 or 15, wherein said first electrode (4a; 5a) and said second electrode (4b; 5b) have different shapes.

**17.** A method as in claim 13 or 14, wherein said first electrode (1a; 2a; 3a) and said second electrode (1b; 2b; 3b) have the same shape.

**Revendications**

**1.** Filtre diélectrique ayant une fréquence de résonance f, comprenant :

un bloc diélectrique (19);
un conducteur extérieur recouvrant la surface extérieure dudit bloc diélectrique (10);
un résonateur configuré avec des trous (10a, 10b) traversant ledit bloc diélectrique (19) et des conducteurs intérieurs recouvrant les surfaces intérieures desdits trous (10a, 10b);
une première électrode (1a, 1b; 2a, 2b; 3a, 3b; 4a, 4b; 5a, 5b) disposée sur une première surface dudit bloc diélectrique (10); et
un premier entrefer (1ag, 1bg; 2ag, 2bg; ... ; 5ag, 5bg) dans ledit conducteur extérieur isolant ladite électrode (1a à 5b) dudit conducteur extérieur,

caractérisé par le fait que ledit entrefer (1ag à 5bg) dans ledit conducteur extérieur présente une surface qui est déterminée de sorte qu'il soit évité que ledit filtre diélectrique ne résonne aux harmoniques d'un signal ayant une fréquence f.

**2.** Filtre diélectrique suivant la revendication 1, dans lequel ledit filtre diélectrique et ladite surface sont déterminés de sorte que la fréquence centrale en mode $TE_{101}$ soit différente de multiples de la fréquence centrale en mode TEM.

**3.** Filtre diélectrique suivant la revendication 1, dans lequel ledit filtre diélectrique est un filtre diélectrique à mode TEM ;

> ledit bloc diélectrique (10) a une forme sensiblement hexaèdre ; et
> ledit premier entrefer (1ag; 2ag; 3ag; 4ag; 5ag) dans ledit conducteur extérieur est prévu autour de la première électrode (1a à 5a);
> ledit filtre diélectrique comprenant, par ailleurs :
>
> > une seconde électrode (1b; 2b; 3b; 4b; 5b) prévue sur une seconde surface du bloc diélectrique (10) adjacente à la première surface, ladite seconde électrode (1b à 5b) étant reliée à ladite première électrode (1a à 5a) ; et
> > un second entrefer (1bg; 2bg; 3bg; 4bg; 5bg) dans le conducteur extérieur prévu autour de ladite seconde électrode (1b à 5b), pour isoler ladite seconde électrode (1b à 5b) dudit conducteur extérieur ;
> > dans lequel les surfaces correspondantes desdits premier et second entrefers (1ag, 1bg à 5ag, 5bg) dans ledit conducteur extérieur sont déterminées de sorte que la fréquence centrale en mode $TE_{101}$ soit différente de multiples de la fréquence centrale en mode TEM.

**4.** Filtre diélectrique suivant la revendication 3, dans lequel la surface dudit premier entrefer (2ag; 3ag; 4ag; 5ag) prévu dans ledit conducteur extérieur est plus grande que la surface dudit second entrefer (2bg; 3bg; 4bg; 5bg) prévu dans ledit conducteur extérieur.

**5.** Filtre diélectrique à mode TEM suivant la revendication 3, dans lequel la surface dudit premier entrefer (1ag) prévu dans ledit conducteur extérieur est plus petite que la surface dudit second entrefer (1bg) prévu dans ledit conducteur extérieur.

**6.** Filtre diélectrique suivant la revendication 1 ou 2, comprenant par ailleurs :

> une seconde électrode (1b; 2b; 3b; 4b; 5b) reliée électriquement à ladite première électrode (1a à 5a) et disposée sur une seconde surface dudit bloc diélectrique (10) aboutant à ladite première surface ; et
> un second entrefer (1bg ; 2bg; 3bg; 4bg; 5bg) dans ledit conducteur extérieur, isolant ladite seconde électrode (1b à 5b) dudit conducteur extérieur,
> dans lequel il est évité que ledit filtre diélectrique ne résonne aux harmoniques de fréquence f en réaction à un rapport entre les surfaces relatives dudit premier entrefer (1ag à 5ag) et dudit second entrefer (1bg à 5bg).

**7.** Filtre diélectrique suivant la revendication 6, dans lequel ledit premier entrefer (3ag) et ledit second entrefer (3bg) présentent des formes extérieures différentes.

**8.** Filtre diélectrique suivant la revendication 6, dans lequel ledit premier entrefer (1ag ; 2ag; 4ag; 5ag) et ledit second entrefer (1bg; 2bg; 4bg; 5bg) présentent la même forme extérieure.

**9.** Filtre diélectrique suivant la revendication 7 ou 8, dans lequel ladite première électrode (4a; 5a) et ladite seconde électrode (4b; 5b) présentent des formes différentes.

**10.** Filtre diélectrique suivant la revendication 6, dans lequel ladite première électrode (1a ; 2a; 3a) et ladite seconde électrode (1b; 2b; 3b) présentent la même forme.

**11.** Filtre diélectrique suivant l'une ou l'autre des revendications 6 à 10, dans lequel ledit bloc diélectrique (10) est de forme hexaèdre.

**12.** Procédé de fabrication d'un filtre diélectrique ayant une fréquence de résonance f, comprenant les étapes consistant à :

> préparer un bloc diélectrique (10) ;
> prévoir un conducteur extérieur recouvrant la surface extérieure dudit bloc diélectrique (10) ;
> prévoir un résonateur configuré avec des trous (10a, 10b) traversant ledit bloc diélectrique (10) et un conducteur intérieur recouvrant les surfaces intérieures desdits trous (10a, 10b);
> disposer au moins une première électrode (1a ; 2a; 3a; 4a; 5a) sur ladite surface extérieure dudit bloc diélectrique; et
> prévoir sur ledit conducteur extérieur un premier entrefer (1ag; 2ag; 3ag; 4ag; 5ag), afin d'isoler l'électrode (1a à 5a) du conducteur extérieur,
>
> caractérisé par les étapes suivantes consistant à :
>
> > sélectionner un premier mode de champ électromagnétique ;
> > spécifier une première zone dans le bloc diélectrique (10) ayant une haute densité de champ électrique ou une haute densité de champ magnétique dans ledit premier mode de champ électromagnétique, dans lequel ladite première électrode est disposée dans la première zone ; et

régler une surface dudit entrefer (1ag à 5ag) de manière à éviter que le filtre diélectrique ne résonne aux harmoniques d'un signal ayant une fréquence de f.

13. Procédé de fabrication suivant la revendication 12, comprenant, par ailleurs, les étapes consistant à :

spécifier une seconde zone dans le bloc diélectrique (10) ayant une haute densité de champ électrique ou une haute densité de champ magnétique à un multiple de la fréquence f dans un second mode de champ électromagnétique ; disposer au moins une seconde électrode (1b à 5b) dans la seconde zone ; prévoir sur ledit conducteur extérieur un second entrefer (1bg; 2bg; 3bg; 4bg; 5bg), afin d'isoler ladite seconde électrode (1b à 5b) du conducteur extérieur ; et régler les surfaces respectives desdits premier et second entrefers de manière que la fréquence centrale dans ledit second mode soit différente de multiples de la fréquence centrale dans le premier mode.

14. Procédé suivant la revendication 13, dans lequel ledit premier entrefer (3ag) et ledit second entrefer (3bg) présentent des formes extérieures différentes.

15. Procédé suivant la revendication 13, dans lequel ledit premier entrefer (1ag; 2ag; 4ag; 5ag) et ledit second entrefer (1bg; 2bg; 4bg; 5bg) présentent la même forme extérieure.

16. Procédé suivant la revendication 14 ou 15, dans lequel ladite première électrode (4a; 5a) et ladite seconde électrode (4b; 5b) présentent des formes différentes.

17. Procédé suivant la revendication 13 ou 14, dans lequel ladite première électrode (1a; 2a; 3a) et ladite seconde électrode (1b; 2b; 3b) présentent la même forme.

**Patentansprüche**

1. Ein dielektrisches Filter, das eine Resonanzfrequenz f aufweist, mit folgenden Merkmalen:

einem dielektrischen Block (10);

einem äußeren Leiter, der die äußere Oberfläche des dielektrischen Blocks (10) bedeckt;

einem Resonator, der mit Löchern (10a, 10b), die durch den dielektrischen Block (10) laufen, und inneren Leitern konfiguriert ist, die innere Oberflächen der Löcher (10a, 10b) bedecken;

einer ersten Elektrode (1a, 1b; 2a, 2b; 3a, 3b; 4a, 4b; 5a, 5b), die auf einer ersten Oberfläche des dielektrischen Blocks (10) angeordnet ist; und

einem ersten Zwischenraum (1ag, 1bg; 2ag, 2bg; ...; 5ag, 5bg) in dem äußeren Leiter, der die Elektrode (1a bis 5b) von dem äußeren Leiter isoliert;

dadurch gekennzeichnet, daß
der Zwischenraum (1ag bis 5bg) in dem äußeren Leiter einen Bereich aufweist, der derart bestimmt ist, daß verhindert wird, daß das dielektrische Filter bei Harmonischen eines Signals, das eine Frequenz f aufweist, in Resonanz tritt.

2. Ein dielektrisches Filter gemäß Anspruch 1, bei dem
das dielektrische Filter ein TEM-Modus-Filter ist, und der Bereich derart bestimmt ist, daß sich die Mittenfrequenz in dem TE$_{101}$-Modus von Vielfachen der Mittenfrequenz in dem TEM-Modus unterscheidet.

3. Ein dielektrisches Filter gemäß Anspruch 1, bei dem

das dielektrische Filter ein dielektrisches TEM-Modus-Filter ist;

der dielektrische Block (10) im wesentlichen eine Hexaeder-Form aufweist; und

der erste Zwischenraum (1ag; 2ag; 3ag; 4ag; 5ag) in dem äußeren Leiter um die erste Elektrode (1a bis 5a) vorgesehen ist;

wobei das dielektrische Filter ferner folgende Merkmale aufweist:

eine zweite Elektrode (1b; 2b; 3b; 4b; 5b), die auf einer zweiten Oberfläche des dielektrischen Blocks (10) vorgesehen ist, die benachbart zu der ersten Oberfläche ist, wobei die zweite Elektrode (1b bis 5b) mit der ersten Elektrode (1a bis 5a) verbunden ist; und

einen zweiten Zwischenraum (1bg; 2bg; 3bg; 4bg; 5bg) in dem äußeren Leiter, der um die zweite Elektrode (1b bis 5b) vorgesehen ist, um die zweite Elektrode (1b bis 5b) von dem äußeren Leiter zu isolieren;

wobei die jeweiligen Bereiche des ersten und des zweiten Zwischenraums (1ag, 1bg bis 5ag, 5bg) in dem äußeren Leiter derart bestimmt sind, daß sich die Mittenfrequenz in dem $TE_{101}$-Modus von Vielfachen der Mittenfrequenz in dem TEM-Modus unterscheidet.

**4.** Ein dielektrisches TEM-Modus-Filter gemäß Anspruch 3, bei dem der Bereich des ersten Zwischenraums (2ag; 3ag; 4ag; 5ag), der in dem äußeren Leiter vorgesehen ist, größer als der Bereich des zweiten Zwischenraums (2bg; 3bg; 4bg; 5bg) ist, der in dem äußeren Leiter vorgesehen ist.

**5.** Ein dielektrisches TEM-Modus-Filter gemäß Anspruch 3,
bei dem der Bereich des ersten Zwischenraums (1ag), der in dem äußeren Leiter vorgesehen ist, kleiner als der Bereich des zweiten Zwischenraums (1bg) ist, der in dem äußeren Leiter vorgesehen ist.

**6.** Ein dielektrisches Filter gemäß Anspruch 1 oder 2, das ferner folgende Merkmale aufweist:

eine zweite Elektrode (1b; 2b; 3b; 4b; 5b), die mit der ersten Elektrode (1a bis 5a) elektrisch verbunden ist, und die auf einer zweiten Oberfläche des dielektrischen Blocks (10) angeordnet ist, die an die erste Oberfläche angrenzt;

einen zweiten Zwischenraum (1bg; 2bg; 3bg; 4bg; 5bg) in dem äußeren Leiter, der die zweite Elektrode (1b bis 5b) von dem äußeren Leiter isoliert;

wobei verhindert wird, daß das dielektrische Filter bei Harmonischen der Frequenz f ansprechend auf eine Beziehung zwischen relativen Bereichen des ersten Zwischenraums (1ag bis Sag) und des zweiten Zwischenraums (1bg, bis 5bg) in Resonanz tritt.

**7.** Ein dielektrisches Filter gemäß Anspruch 6, bei dem der erste Zwischenraum (3ag) und der zweite Zwischenraum (3bg) unterschiedliche äußere Formen aufweisen.

**8.** Ein dielektrisches Filter gemäß Anspruch 6, bei dem der erste Zwischenraum (1ag; 2ag; 4ag; 5ag) und der zweite Zwischenraum (1bg; 2bg; 4bg; 5bg) die gleiche äußere Form aufweisen.

**9.** Ein dielektrisches Filter gemäß Anspruch 7 oder 8, bei dem die erste Elektrode (4a; 5a) und die zweite Elektrode (4b; 5b) unterschiedliche Formen aufweisen.

**10.** Ein dielektrisches Filter gemäß Anspruch 6, bei dem die erste Elektrode (1a; 2a; 3a) und die zweite Elektrode (1b; 2b; 3b) die gleiche Form aufweisen.

**11.** Ein dielektrisches Filter gemäß einem der Ansprüche 6 bis 10, bei dem der dielektrische Block (10) hexaederförmig ist.

**12.** Ein Herstellungsverfahren eines dielektrischen Filters, das eine Resonanzfrequenz f aufweist, mit folgenden Schritten:

Vorbereiten eines dielektrischen Blocks (10);

Vorsehen eines äußeren Leiters, der die äußere Oberfläche des dielektrischen Blocks (10) bedeckt;

Vorsehen eines Resonators, der mit Löchern (10a, 10b), die durch den dielektrischen Block (10) laufen, und einem inneren Leiter konfiguriert ist, der die inneren Oberflächen der Löcher (10a, 10b) bedeckt;

Anordnen mindestens einer ersten Elektrode (1a; 2a; 3a; 4a; 5a) auf der äußeren Oberfläche des dielektrischen Blocks; und

Vorsehen eines ersten Zwischenraums (1ag; 2ag; 3ag; 4ag; 5ag) in dem äußeren Leiter, um die Elektrode (la bis 5a) von dem äußeren Leiter zu isolieren;

gekennzeichnet durch die folgenden Schritte:

Auswählen eines ersten elektromagnetischen Feldmodus;

Spezifizieren eines ersten Bereichs in dem dielektrischen Block (10), der eine hohe elektrische Felddichte oder eine hohe magnetische Felddichte in dem ersten elektromagnetischen Feldmodus aufweist, wobei die erste Elektrode in dem ersten Bereich angeordnet ist; und

Einstellen eines Bereichs des Zwischenraums (1ag bis 5ag), um zu verhindern, daß das dielektrische Filter bei Harmonischen eines Signals, das eine Frequenz f aufweist, in Resonanz tritt.

**13.** Ein Herstellungsverfahren gemäß Anspruch 12, das ferner folgende Schritte aufweist:

Spezifizieren eines zweiten Bereichs in dem dielektrischen Block (10), der eine hohe elektrische Felddichte oder eine hohe magnetische Felddichte bei einem Vielfachen der Frequenz f in einem zweiten elektromagnetischen Feldmodus aufweist;

Anordnen mindestens einer zweiten Elektrode (1b bis 5b) in dem zweiten Bereich;

Vorsehen auf dem äußeren Leiter eines zweiten Zwischenraums (1bg; 2bg; 3bg; 4bg; 5bg), um die zweite Elektrode (1b bis 5b) von dem äußeren Leiter zu isolieren; und

Einstellen jeweiliger Bereiche des ersten und des zweiten Zwischenraums, derart, daß sich die Mittenfrequenz in dem zweiten Modus von Vielfachen der Mittenfrequenz in dem ersten Modus unterscheidet.

**14.** Ein Verfahren gemäß Anspruch 13, bei dem der erste Zwischenraum (3ag) und der zweite Zwischenraum (3bg) unterschiedliche äußere Formen aufweisen.

**15.** Ein Verfahren gemäß Anspruch 13, bei dem der erste Zwischenraum (1ag; 2ag; 4ag; 5ag) und der zweite Zwischenraum (1bg; 2bg; 4bg; 5bg) die gleiche äußere Form aufweisen.

**16.** Ein Verfahren gemäß Anspruch 14 oder 15, bei dem die erste Elektrode (4a; 5a) und die zweite Elektrode (4b; 5b) unterschiedliche Formen aufweisen.

**17.** Ein Verfahren gemäß Anspruch 13 oder 14, bei dem die erste Elektrode (1a; 2a; 3a) und die zweite Elektrode (1b; 2b; 3b) die gleiche Form aufweisen.

**FIG.1**

**FIG.2**

**FIG.3**

**FIG.4**

**FIG.5**

**FIG.6**

*FIG.7*

*FIG.8*

PEAK IN VICINITY OF
RESONANT FREQUENCY
IN TEM MODE

PEAK GENERATED BY COUPLING
OF MAGNETIC FIELD IN $TE_{101}$ MODE
AND TEM HARMONICS

SIGNAL-PASSING
CHARACTERISTICS

f 0

2f 0

FREQUENCY

*FIG.9*